# EUROPEAN PATENT APPLICATION

(11) **EP 4 718 454 A1**
(43) Date of publication of application: **01.04.2026**
(21) Application number: 25202170.4
(22) Date of filing: 15.09.2025
(51) Int. Cl.: G11C 11/22

(54) **NON-VOLATILE MEMORY CELL, RANDOM-ACCESS MEMORY, AND METHODS OF OPERATION THEREOF**

(30) Priority: 25.09.2024 CN 202411342751
(71) Applicant: LoMaRe Technologies Limited, London Greater London EC3R 7LP (GB); LoMaRe Chip Technology Changzhou Co., Ltd., Changzhou City Jiangsu (CN)
(72) Inventor: EL HAJJI, Noureddine, London, EC3R 7LP (GB); ZOU, Bin, London, EC3R 7LP (GB); MIHAI, Andrei Paul, London, EC3R 7LP (GB)
(74) Representative: Mathys & Squire

(57) **Abstract**

Disclosed is a non-volatile memory cell, random-access memory and methods of operation thereof which solve the existing problem of lack of voltage-controlled FReRAM memory cell architecture and control methods, which relate to the technical field of non-volatile memory. The memory cell comprises a first memory element including a first ferroelectric tunnel junction (FTJ) device programmable to one of a high or low resistance state, and a second memory element comprising a second FTJ device programmable to the other of a high or low resistance state, and wherein the memory cell stores a data bit represented by the opposite resistance states of the first FTJ device and the second FTJ device. The memory cell is read by comparing the resistance states of the first FTJ device and the second FTJ device during a read operation. Also disclosed are methods of performing read and write operations on the memory cell, and a random-access memory comprising an array of the memory cells.

## Description

### Technical Field

The invention relates generally to the field of memory technology, in particular to a non-volatile memory cell, random-access memory, preferably based on ferroelectric tunnel junction devices, and methods of operation.

### Background to the Invention

Ferroelectric resistive random-access memory (FReRAM) is an emerging class of voltage-controlled non-volatile RAM technology offering larger ON/OFF resistance ratios and faster read and write times together with lower power consumption and greater scalability compared to leading magnetoresistive non-volatile RAM technologies such as spin transfer torque MRAM. FReRAM is based on ferroelectric tunnel junctions (FTJs), whereby the logic state ("0" or "1") of the memory cell is encoded in the polarisation direction of a ferroelectric tunnel barrier layer sandwiched between two different electrode layers (which may be magnetic or non-magnetic), which is switchable/reversible by applying a threshold electric field or voltage across the FTJ resulting in distinct (ON and OFF) device resistances. This is in contrast to MRAM which is current-driven, requiring a threshold current to write data. State-of-the-art FReRAM solutions include piezomagnetic RAM (PMRAM), as described in GB2576174A. Despite the inherent advantages of FReRAM over existing MRAM technologies, the development of memory cell architectures and control methodologies for voltage-controlled FReRAM is still at a relatively nascent stage.

Aspects and embodiments of the present invention have been devised with the foregoing in mind.

### Summary of the Invention

To overcome the above technical deficiencies, the object of the present invention is to provide a non-volatile memory cell, random-access memory and methods of performing a read and write operation on the same.

According to a first aspect of the invention, there is provided a memory cell, preferably a non-volatile memory cell. The memory cell comprises a first memory element comprising a first ferroelectric tunnel junction (FTJ) device programmable to one of a high or low resistance state (representing logical 0 or 1); and a second memory element comprising a second FTJ device programmable to the other of a high or low resistance state; wherein the memory cell stores a data bit represented by the opposite resistance states of the first FTJ device and the second FTJ device.

By providing a single memory cell including a first and second memory element programmed to oppositive resistance states that represent the stored data bit, the advantage of a more robust memory cell architecture that is less prone to process variations and can provide a low bit error rate can be afforded. In particular, the data bit is readable or can be read by direct comparison of the different resistance states of the first and second FTJ devices during a read operation. Thus, any process variations across a memory chip will affect the characteristics of the first and second FTJ devices in substantially the same way. This in turn avoids the need for a separate well-calibrated reference cell (which is commonplace in MRAM architectures), which typically requires a fixed equivalent resistance equal to the average of the two resistance states of the memory element being read. By programming the first and second memory elements to opposite resistance (logic) states, the read signal contrast between the first and second memory elements can be maximised to help reduce the bit error rate.

The memory cell may be a random-access memory (RAM) cell or be referred to as a ferroelectric resistive memory or RAM cell. In the context of the present invention, non-volatile means that the memory cell can retain stored information even after power is removed.

Preferably, the first FTJ device is programmed to one of the high or low resistance states based on the stored data bit, and the second FTJ device is programmed to the other of the high or low resistance states. The first FTJ device may be configured to store a data bit as one of the high or low resistance states, and the second FTJ device may be configured to store the logical complement of the data bit as the other of the high or low resistance states.

Preferably, the first FTJ device and the second FTJ device are substantially identical and co-located. This may minimise any variation in the electrical characteristics between the two memory elements of the memory cell, e.g. caused by process variations. The term "substantially identical" will be understood to mean the devices are intended to have the same structure, size and shape, however, considering the process variations caused by manufacturing technologies, the devices may in practice have minor differences in structure, size and shape. Likewise, the term "substantially co-located" will be understood to mean that the positions of the devices occupy the same general location on a substrate, e.g. side-by-side or adjacent one another, but will in practice have a certain displacement relative to each other.

Preferably, the data bit is readable or read by comparison of the resistance states of the first and second FTJ devices during a read operation.

The second memory element may be a reference cell that is preferably programmed oppositely to the first memory element. For example, if the first memory element is programmed to logical 0 (high resistance state), then the second memory element is programmed to its logical complement 1 (low resistance state), and vice versa. This may allow the memory cell to be read by comparison of read signals produced locally at the memory cell, as opposed to comparing a read signal from a single element memory cell to a read signal produced from a reference cell located remotely from the memory cell (e.g., at the periphery of a memory array and/or in a sense amplifier), which can account for process variations across the chip and which is particularly useful for testing applications.

The memory cell may comprise a first bit line, a first source line, a first memory element, and a first access switch, wherein the first memory element and the first access switch are connected in series between the first bit line and the first source line. The memory cell may further comprise a second bit line, a second source line, a second memory element, and a second access switch, wherein the second memory element and the second access switch are connected in series between the second bit line and the second source line. The memory cell may further comprise a word line connected to a control input of the first access switch and to a control input of the second access switch for providing an activation signal thereto during a read operation and a write operation of the memory cell.

For the same reason, by providing a single memory cell with a data stored in the first and second memory elements in a bit-bitbar line architecture, the advantage of a more robust memory cell architecture that is less prone to process variations and can provide a low bit error rate can be afforded.

Preferably, the first FTJ device and the second FTJ device are two terminal devices. Preferably, the first FTJ device and the second FTJ device each comprise a first electrode layer and a second electrode layer separated by a ferroelectric tunnel barrier. Preferably, the ferroelectric tunnel barrier is non-magnetic.

At least one of the first electrode layer and the second electrode layer of the first FTJ device and the second FTJ device may be formed of or comprise a magnetic material.

Preferably, at least one of the first electrode layer and the second electrode layer of the first FTJ device and the second FTJ device is formed of or comprises a magnetically frustrated material. The magnetically frustrated material is preferably an antiferromagnetic material.

By using a magnetically frustrated, preferably antiferromagnetic, electrode layer on one side of the ferroelectric tunnel barrier layer, the advantage of enhanced ON/OFF resistance ratio of the memory elements while exhibiting small (near zero) net magnetic moment may be afforded. This may allow for smaller read voltages, closer packing of memory cells, and higher maximum operating temperatures compared to MRAM.

The antiferromagnetic material may be piezomagnetic, whereby its magnetic properties are sensitive to an applied electric field and the electric polarisation of the ferroelectric tunnel barrier which it is in contact with. In this case, the first FTJ device and the second FTJ device may be referred to as piezomagnetic memory elements.

The antiferromagnetic material is preferably an antiperovskite material or has an antiperovskite crystal structure. Preferably, the ferroelectric tunnel barrier is comprised of a perovskite material or a material with a perovskite crystal structure.

Preferably, at least one of the first and second electrode layers of the first FTJ device and the second FTJ device comprises a material (magnetic or nonmagnetic) with an anti-perovskite crystal structure, and preferably the ferroelectric tunnel barrier is comprised of a material with a perovskite crystal structure. The antiperovskite material is preferably antiferromagnetic.

The use of a perovskite ferroelectric tunnel barrier and an anti-perovskite electrode can provide high mechanical stability and good lattice match between the individual layers which promotes high quality interfaces and high endurance.

Example antiperovskite materials including those with a general formula of Mn₃XN where X can, for example, be Ga, Ni, Sn. Preferred examples include Mn₃GaN or Mn₃NiN based materials, such as Mn₃₋ₓAₓGa_{1-y}B_{y}N_{1-z} or Mn₃₋ₓAₓNi_{1-y}B_{y}N_{1-z}, where A and B are one or more elements selected from the list including: Ag, Al, Au, Co, Cu, Fe, Ga, Ge, In, Ir, Ni, Pd, Pt, Rh, Sb, Si, Sn, and Zn, and x, y and z are composition parameters in the range from 0 to 1.

The memory cell may be a piezomagnetic random access memory cell, whereby each of the first FTJ device and the second FTJ device are piezomagnetic memory elements (i.e., comprising a piezomagnetic electrode layer on one side of the ferroelectric tunnel barrier).

The first access switch and the second access switch may each comprise a transistor. The transistor may be an n-type transistor or a p-type transistor. The transistors are preferably metal-oxide-semiconductor transistors (referred to as nmos and pmos), but it will be appreciated that any suitable type of transistor can be used. The transistors (n-type or p-type) preferably have a control input (e.g., a gate electrode) connected to the word line. The first access switch and the second access switch (and their respective transistors) are preferably normally closed or OFF (i.e., closed or OFF in the absence of an activation signal applied thereto).

Preferably, the first access switch and the second access switch each comprise a plurality of transistors (n-type or p-type connected in parallel). By using multiple transistors in parallel the advantage of using of lower read voltages and FTJs with higher switching voltages (thus reducing the risk of disrupting the state of the memory element when reading) can be afforded. In particular, reducing the effective resistance of the first access switch and the second access switch means that less of the applied voltage during a read or write operation is dropped across the access switches.

The first access switch and the second access switch may each comprise an n-type transistor and a p-type transistor connected in parallel. In this case, each n-type (or p-type) transistor has a control input connected to the word line, and the memory cell comprises a further word line connected to a control input of the respective p-type (or n-type) transistor of the first access switch and the second access switch for providing an activation signal thereto during a read operation and/or a write operation. Preferably, the n-type transistors and the p-type transistors of the first access switch and the second access switch are metal-oxide-semiconductor transistors. The use of n-type and p-type transistors in parallel may advantageously further lower the equivalent ON resistance of the access switch.

According to a second aspect of the invention, there is provided a method of performing a write operation on the memory cell of the first aspect. The method comprises applying a first write voltage of a first polarity across the first ferroelectric tunnel junction (FTJ) device of the first memory cell to program the first FTJ device to one of the high or low resistance states, wherein the first polarity is based on a data bit (i.e. 1 or 0) to be written to the memory cell; and applying a second write voltage of a second polarity across the second FTJ device of the second memory cell to program the second FTJ device to the other of the high or low resistance states, wherein the second polarity is opposite to the first polarity; and wherein the data bit is represented by the opposite resistance states of the first FTJ device and the second FTJ device.

By applying the first write voltage and the second write voltage of opposite polarity to the respective first FTJ device and second FTJ device of the memory cell, the advantages of more robust and reliable cell readout that is less prone to process variations can be realised, as discussed for the first aspect.

The data bit is represented by the resistance states (logical states) of the first FTJ device and the second FTJ device. For example, a data bit 0 may be represented by a logical state 0 of the first FTJ device and a logical state 1 of the second FTJ device, and vice versa. Preferably, the first polarity of the first write voltage is selected to program the first FTJ device to the logical value (0 or 1) of the desired data bit (0 or 1) to be stored, and the second polarity of the second write voltage is selected to program the second FTJ device to the opposite logical value (1 or 0). This architecture then facilitates reading of the memory cell by directly comparing the different resistance (logical) states of the first FTJ device and the second FTJ device.

The first write voltage and the second write voltage are preferably greater than a threshold switching voltage of the respective first FTJ device and second FTJ device.

Preferably, the method further comprises: receiving a data signal indicating a logical state, 0 or 1, of the data bit to be written to the memory cell; and selecting a positive or negative first polarity of the first write voltage based on the data signal.

Preferably, the memory cell comprises: a first bit line, a first source line, and a first access switch, wherein the first memory element and the first access switch connected in series between the first bit line and the first source line; and a second bit line, a second source line, and a second access switch, wherein the second memory element and the second access switch are connected in series between the second bit line and the second source line; and a word line connected to a control input of the first access switch and to a control input of the second access switch for providing an activation signal thereto.

In this case, the step of applying the first write voltage and the second write voltage across the respective first FTJ device and second FTJ device preferably comprises: applying the first write voltage of the first polarity between the first bit line and the first source line of the memory cell; applying the second write voltage of the second polarity, between the second bit line and the second source line of the memory cell; and activating the first access switch and the second access switch of the memory cell, preferably for a predefined period of time. Activating the first access switch and the second access switch enables the first write voltage and the second write voltage to be applied across the respective first FTJ device and second FTJ device to thereby program the first FTJ device to one of the high or low resistance states (logical 0 or 1) based on the first write voltage and program the second FTJ device to the other of the high or low resistance states (logical 1 or 0) based on the second write voltage. Activating the first access switch and the second access switch may comprise opening or turning ON the switches. Activating the first access switch and the second access switch preferably comprises providing an activation signal to the word line of the memory cell, preferably for a predefined period of time. The activation signal is an electrical signal, preferably a voltage, applied to the control inputs of the first access switch and the second access switch.

Preferably, the method further comprises, prior to applying the first write voltage and the second write voltage: setting a voltage on the first bit line, the second bit line, the first source line, and the second source line to zero voltage or ground.

Preferably, the first access switch and the second access switch of the memory cell each comprise an n-type transistor and a p-type transistor connected in parallel, each n-type transistor having a control input connected to the word line and each p-type transistor having a control input connected to a further word line of the memory cell. In this case, the step of activating the first access switch and the second access switch may further comprise providing an activation signal to the further word line of the memory cell. The activation signals applied to the word line and further word line may be different, e.g., opposite polarity electrical signals. For example, a p-type transistor may be activated by applying a negative voltage to the control input (gate electrode), and an n-type transistor may be activated by applying a positive voltage to the control input (gate electrode).

According to a third aspect of the invention, there is provided a method of performing a read operation on the memory cell of the first aspect. The method comprises applying a read voltage across the first ferroelectric tunnel junction (FTJ) device of the first memory cell to thereby produce a first read current flowing through the first FTJ device; applying a read voltage across the second FTJ device of the second memory cell to thereby produce a second read current flowing through the second FTJ device; and comparing the first read current and the second read current to determine a data bit stored in the memory cell.

For similar reasons provided above, by comparing the first read current and the second read current from the oppositely programmed first FTJ device and second FTJ device, the advantage of more robust and reliable data readout which is less prone to process variations and thus a lower bit error rate, can be afforded. In particular, since the first read current and the second read current are inversely proportional to the resistance (logical) states of the respective first FTJ device and second FTJ device, the ratio or difference between the first read current and the second read current for a given memory cell is maximal.

Preferably, the memory cell comprises: a first bit line, a first source line, and a first access switch, wherein the first memory element and the first access switch connected in series between the first bit line and the first source line; and a second bit line, a second source line, and a second access switch, wherein the second memory element and the second access switch are connected in series between the second bit line and the second source line; and a word line connected to a control input of the first access switch and to a control input of the second access switch for providing an activation signal thereto.

In this case, applying the read voltage across the first FTJ device and the second FTJ device preferably comprises: applying a read voltage between the first bit line and the first source line and between the second bit line and the second source line of the memory cell; and activating the first access switch and the second access switch of the memory cell, preferably for a predefined period of time.

Activating the first access switch and the second access switch enables the read voltage to be applied across the respective first FTJ device and second FTJ device to thereby cause a respective read current to flow therethrough. Activating the first access switch and the second access switch may comprise providing an activation signal to the word line of the memory cell, preferably for a predefined period of time. The activation signal is an electrical signal, preferably a voltage, applied to the control inputs of the first access switch and the second access switch. Activating the first access switch and the second access switch may comprise opening or turning ON the access switches.

The read voltage is less than a threshold switching voltage of the respective first FTJ device and second FTJ device. Preferably, the read voltage applied to the first FTJ device and the second FTJ device is substantially the same.

Preferably, the method further comprises, prior to applying the read voltage: setting a voltage on the first bit line, the second bit line, the first source line, and the second source line to zero or ground.

Preferably, the first access switch and the second access switch of the memory cell each comprise an n-type transistor and a p-type transistor connected in parallel, each n-type transistor having a control input connected to the word line and each p-type transistor having a control input connected to a further word line of the memory cell. In this case, the step of activating the first access switch and the second access switch may further comprise providing an activation signal to the further word line of the memory cell. The activation signals applied to the word line and further word line may be different, e.g., opposite polarity electrical signals.

Preferably, comparing the read currents in the first source line and the second source line of the memory cell to determine a data bit comprises using a current sense amplifier connected to the first source line and the second source line. Preferably, the output of the current sense amplifier is proportional to a logical state, 0 or 1, of the data bit stored in the memory cell.

According to a fourth aspect of the invention, there is provided a random-access memory (RAM), preferably a non-volatile RAM architecture. The random-access memory comprises an array of memory cells according to the first aspect, preferably arranged in a plurality of rows and columns.

Each memory cell comprises: a first bit line, a first source line, and a first access switch, wherein the first memory element and the first access switch are connected in series between the first bit line and the first source line; a second bit line, a second source line, and a second access switch, wherein the second memory element and the second access switch are connected in series between the second bit line and the second source line; and a word line connected to a control input of the first access switch and to a control input of the second access switch for providing an activation signal thereto. The respective first bit lines, second bit lines, first source lines and second source lines of the memory cells in the same column are serially connected, and the respective word lines of the memory cells in the same row are serially connected. The random-access memory further comprises a peripheral control circuit coupled to the array of memory cells for performing voltage-driven read and/or write operations on individual selected memory cells of the array. The peripheral control circuit is configured, during a read operation, to: apply a read voltage between the first bit line and the first source line and between the second bit line and the second source line of a column of memory cells containing a selected memory cell for reading; activate the first access switch and the second access switch of the selected memory cell by providing an activation signal to the word line of a row of memory cells containing the selected memory cell to thereby enable a read current to flow through the first FTJ device and the second FTJ device of the selected memory cell; and compare the read current flowing in the first source line and the second source line of the selected column of memory cells to determine a data bit stored in the selected memory cell. The peripheral control circuit may be configured to perform the method of the second aspect on the selected memory cell. The peripheral control circuit is further configured, during a write operation, to: apply a first write voltage of a first polarity between the first bit line and the first source line of a column of memory cells containing a selected memory cell for writing, wherein the first polarity is based on a data bit to be written to the selected memory cell; apply a second write voltage of a second polarity between the second bit line and the second source line of the column of memory cells containing the selected memory cell, wherein the second polarity is opposite to the first polarity; and activate the first access switch and the second access switch of the selected memory cell by providing an activation signal to the word line of a row of memory cells containing the selected memory cell, to thereby program the first FTJ device of the selected memory cell to one of the high or low resistance states based on the first write voltage and program the second FTJ device of the selected memory cell to the other of the high or low resistance states based on the second write voltage. The peripheral control circuit may be configured to perform the method of the third aspect on the selected memory cell.

By providing a random-access memory (RAM) architecture with memory cells that include first and second non-volatile memory elements programmable in a bit-bitbar line configuration, the advantage of a random bit accessible memory with zero latency in both read and write operations can be afforded.

Preferably, the peripheral control circuit is further configured, prior to applying the read voltage and the first write voltage and the second write voltage, to: set a voltage on the first bit line, the second bit line, the first source line, and the second source line to zero voltage or ground.

Preferably, the peripheral control circuit is further configured to: receive a data signal indicating a logical state, 0 or 1, of the data bit to be written to the selected memory cell; and select a positive or negative first polarity of the first write voltage based on the data signal.

Preferably, the first access switch and the second access switch of each memory cell of the array each comprise an n-type transistor and a p-type transistor connected in parallel, each n-type transistor having a control input connected to the word line of the respective memory cell and each p-type transistor having a control input connected to a further word line of the respective memory cell, wherein the respective further word lines of the memory cells in the same row are serially connected. In this case, the peripheral control circuit is further configured to activate the first access switch and the second access switch of the selected memory cell by further providing an activation signal to the further word line of the row of memory cells containing of the selected memory cell.

Preferably, the peripheral control circuit is configured to perform a read or write operation within a clock cycle (e.g., of the peripheral control circuitry).

In an embodiment, the peripheral control circuit comprises one or more of: a row decoder coupled to the word lines of each row of memory cells for selecting a row of memory cells for a read and/or write operation; a column selector coupled to the first bit line and the second bit line and the first source line and the second source line of each column of memory cells for selecting a column of memory cells for a read and/or write operation; a pre-charge circuit coupled to the first bit line and the second bit line and the first source line and the second source line of each column of memory cells for setting their respective voltages to zero or ground; a read-write driver coupled to the column selector for applying a read and/or write voltage to the selected column of memory cells during a respective read and/or write operation; a current sense amplifier coupled to the column selector, the current sensor amplifier configured to compare read currents in the first source line and the second source line of the selected column of memory cells during a read operation and provide an output signal proportional to a logical state, 0 or 1, of the data bit of (or stored in) the selected memory cell; and a controller coupled to the row decoder, column selector, pre-charge circuit, read-write driver and current sense amplifier for controlling the read and/or write operations.

Preferably, the controller is configured, in response to receiving an input write signal indicating the row and column address of a selected memory cell for writing, to: select a memory cell of the array for writing.

Preferably, the controller is configured, in response to receiving an input write signal indicating the row and column address of a selected memory cell for writing, to: provide a row address signal to the row decoder to select a row containing the selected memory cell for writing and provide a column address signal to the column selector to select a column containing the selected memory cell for writing; optionally provide an enable signal to the pre-charge circuit to set the first bit line, the second bit line, the first source line, and the second source line of the selected column of memory cells to zero voltage or ground; provide a write enable signal to the read-write driver to apply (through the column selector) the first write voltage between the first bit line and the first source line of the selected column of memory cells and the second write voltage between the second bit line and the second source line of the selected column of memory cells, wherein the polarity of the first write voltage is based on an input data signal indicating a logical state, 0 or 1, of the data bit to be written to the selected memory cell; and provide an activation signal to the word line of the selected row of memory cells.

Preferably, the controller is configured, in response to receiving an input read signal indicating the row and column address of a selected memory cell for reading, to: select a memory cell of the array for reading.

Preferably, the controller is configured, in response to receiving an input read signal indicating the row and column address of a selected memory cell for reading, to: provide a row address signal to the row decoder to select a row containing the selected memory cell for reading and provide a column address signal to the column selector to select a column containing the selected memory cell for reading; optionally provide an enable signal to the pre-charge circuit to set the first bit line, the second bit line, the first source line, and the second source line of the selected column of memory cells to zero voltage or ground; provide a read enable signal to the read-write driver to apply (through the column selector) the read voltage between the first bit line and the first source line and between the second bit line and the second source line of the selected column of memory cells; and provide an activation signal to the word line of the selected row of memory cells.

Any feature of the memory cell or random access memory as described herein may also be provided as a method feature, and vice versa. As used herein, means plus function features may be expressed alternatively in terms of their corresponding structure. Any, some and/or all features in one aspect of the invention may be applied to other aspects of the invention, in any appropriate combination or subcombination. In particular, device aspects may be applied to method aspects, and vice versa.

It should also be appreciated that particular combinations of the various features described and defined in any aspect of the invention can be implemented and/or supplied and/or used independently. The invention extends to the methods, memory cell and architecture substantially as herein described and/or as illustrated with reference to the accompanying figures. The invention also extends to any novel aspects or features described and/or illustrated herein. In this specification the word 'or' can be interpreted in the exclusive or inclusive sense unless stated otherwise.

The disclosure will now be described, by way of example, with reference to the accompanying drawings.

### Brief Description of Drawings

In order that the invention can be well understood, embodiments will now be discussed by way of example only with reference to the accompanying drawings, in which:
**Figure 1** is a schematic diagram of a memory element comprising a ferroelectric tunnel junction (FTJ) device;
**Figure 2** is a schematic diagram of the electrical characteristics of a FTJ device;
**Figure 3** is a schematic diagram of a non-volatile memory cell according to an embodiment of the invention;
**Figures 4(a) to 4(d)** show schematic diagrams of different transistor configurations for an access switch of the memory cell of figure 3;
**Figure 5** shows a schematic diagram of a method of performing a write operation on the memory cell of figure 3;
**Figure 6** shows a schematic diagram of a method of performing a read operation on the memory cell of figure 3;
**Figure 7** shows a schematic diagram of a ferroelectric resistive random-access memory (FReRAM) architecture according to an embodiment of the invention;
**Figure 8** shows a schematic signal timing diagram for a write operation using the FReRAM architecture of figure 7; and
**Figure 9** shows a schematic signal timing diagram for a read operation using the FReRAM architecture of figure 7.

It should be noted that the figures are diagrammatic and may not be drawn to scale. Relative dimensions and proportions of parts of these figures may have been shown exaggerated or reduced in size, for the sake of clarity and convenience in the drawings. The same reference signs are generally used to refer to corresponding or similar features in modified and/or different embodiments.

### Detailed Description

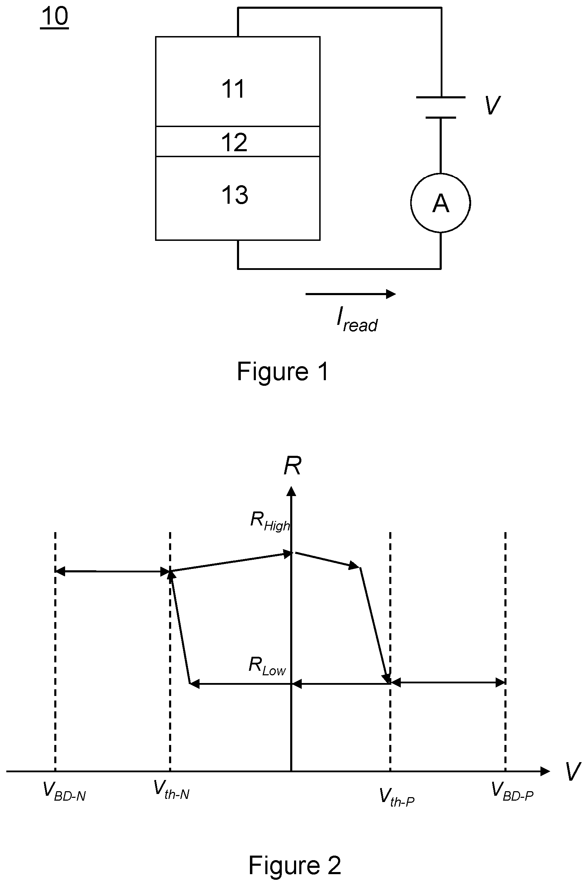

Figure 1 shows schematic diagram of a resistive memory element comprising a ferroelectric tunnel junction (FTJ) device 10 as used in embodiments of the present invention. The FTJ device 10 is a two-terminal device comprising a first electrode layer 11 and a second electrode layer 13 separated by a ferroelectric tunnel barrier 12. Preferably, the ferroelectric tunnel barrier 12 is non-magnetic, while the electrode layers can be magnetic or non-magnetic. The logic state ("0" or "1") of the memory element is encoded in the polarisation direction of a ferroelectric tunnel barrier 12, which is switchable/reversible by applying a threshold electric field or voltage V across the FTJ device 10 resulting in distinct and persistent high (OFF) and low (ON) device resistances, known as tunnelling electroresistance (TER). The logical state of the memory element can then be read non-destructively by applying a small read voltage, below the threshold switching voltage, across the FTJ device 10 and measuring the resulting read current *I*_{read} flowing in the circuit. The FTJ device 10 thus constitutes a non-volatile (ferroelectric) memory element.

Figure 2 illustrates the idealised electrical characteristics of an FTJ device 10. Starting in a low resistance (ON or logic 1) state, R_{Low}, application of a negative voltage between the first electrode layer 11 and the second electrode layer 13 of the FTJ device 10 at or above a first threshold negative voltage (referred to as a threshold switching voltage), V_{th-N}, causes the polarisation direction of a ferroelectric tunnel barrier 12 to switch/reverse and the resistance of the FTJ device 10 to increase to a high resistance (OFF or logic 0) state, R_{High}. Further increase of the applied negative voltage V beyond a second threshold negative voltage (referred to as a breakdown voltage), V_{BD-N}, results in irreversible electrical breakdown of the ferroelectric tunnel barrier 12. Upon reduction of the applied voltage to zero (without having reached the breakdown voltage) the resistance remains at R_{High}. Starting now at the high resistance state, R_{High}, application of a positive voltage between the first electrode layer 11 and the second electrode layer 13 of the FTJ device 10 at or above a first threshold positive voltage (referred to as a threshold switching voltage), V_{th-P}, causes the polarisation direction of a ferroelectric tunnel barrier 12 to switch/reverse and the resistance of the FTJ device 10 to return to the low resistance state, R_{Low}. Again, further increase of the applied positive voltage V beyond a second threshold positive voltage (referred to as a breakdown voltage), V_{BD-P}, results in irreversible electrical breakdown of the ferroelectric tunnel barrier 12. Upon reduction of the applied voltage to zero (without having reached the breakdown voltage) the resistance remains at R_{Low}. As such, the FTJ device 10 acts as a programmable resistor suitable for non-volatile RAM.

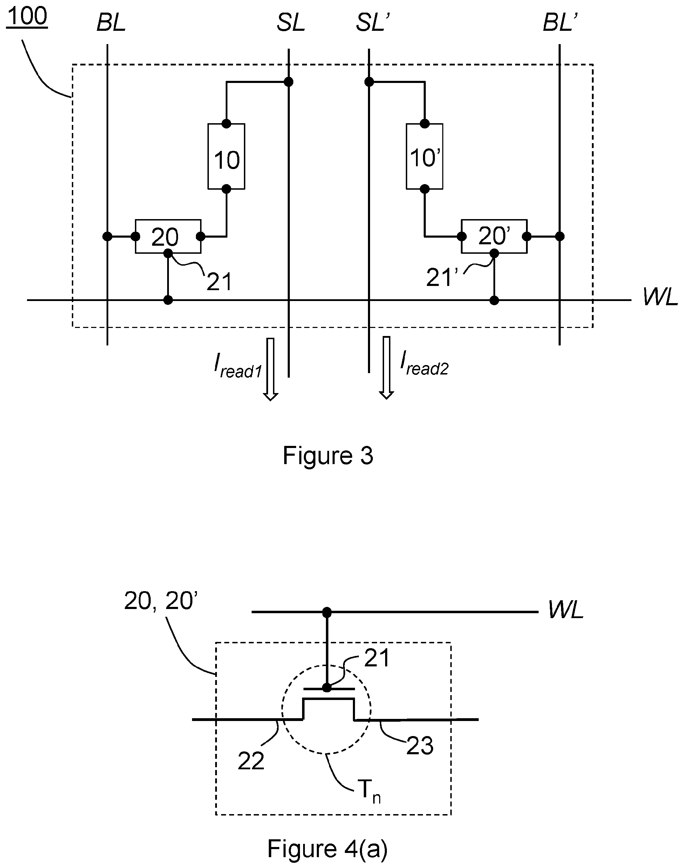

Figure 3 shows a schematic diagram of a non-volatile memory cell 100 according to an embodiment of the invention. The memory cell 100 includes two programmable ferroelectric resistive memory elements 10, 10' as described above with reference to figure 1 to store a single data bit in a bit-bitbar line architecture that enables robust read out of the stored data bit by comparison of complimentary read currents *I_{read1}*, *I_{read2}* produced locally at the memory cell 100. The memory cell 100 is thus a ferroelectric resistive random-access memory (FReRAM) cell. Specifically, the memory cell 100 comprises a first bit line BL, a first source line SL, a first (ferroelectric) memory element 10 and a first access switch 20, whereby the first (ferroelectric) memory element 10 and the first access switch 20 are connected in series between the bit line BL and the source line SL. The memory cell 100 further comprises a second bit line BL', a second source line SL', a second (ferroelectric) memory element 10' and a second access switch 20', whereby the second (ferroelectric) memory element 10' and the second access switch 20' are connected in series between the second bit line BL' and the second source line SL'. The memory cell 100 further comprises a word line WL connected to a control input 21 of the first access switch 20 and to a control input 21' of the second access switch 20' for providing an activation signal thereto during a read operation and a write operation.

The first access switch 20 and the second access switch 20' control electrical access to the first (ferroelectric) memory element 10 and the second (ferroelectric) memory element 10' during a read operation or a write operation. Specifically, the first access switch 20 and the second access switch 20' are switchable between an open circuit (OFF) state and a closed circuit (ON) state in response to the activation signal applied to the respective control inputs 21, 21'. Preferably, the first access switch 20 and the second access switch 20' are configured to be normally OFF (open circuit) in the absence of an activation signal (or zero voltages) and switched ON (closed circuit) in response to the activation signal applied during a read operation or a write operation. Thus, when an activation signal is applied to the word line WL, a read or write voltage applied between the first bit line BL and first source line SL, and between the second bit line BL' and second source line SL' will be applied across the respective first FTJ device 10 and second FTJ devices 10' of the first memory element and the second memory element, enabling reading and writing of the memory cell 100.

Each of the first FTJ device and the second FTJ device of the first memory elements 10 and the second memory elements 10' are programmable to one of a high or low resistance state representing logical 0 or 1, as described above, and the memory cell 100 stores a data bit (i.e. 0 or 1) represented by the resistance (logical) states of the first FTJ device 10 and the second FTJ device 10'. In preferred embodiments, the first FTJ devices 10 and the second FTJ devices 10' are programmed to opposite resistance (logical) states, thus facilitating the read out of the data bit by comparison of the resistance (logical) states of the first FTJ device and the second FTJ device during a read operation.

Specifically, the first FTJ device 10 is programmable or programmed to one of a high or low resistance state in response to a first write voltage V_{w1} applied between the first bit line BL and the first source line SL during a write operation, and the second FTJ device 10' is programmable or programmed to the other of the high or low resistance state in response to a second write voltage V_{w2} applied between the second bit line BL' and the second source line SL' during a write operation. The polarity of the first write voltage V_{w1} is based on the data bit (i.e. 1 or 0) to be written to the memory cell 100, and the second polarity is opposite to the first polarity. For example, if the data bit to be stored by the memory cell 100 is "1", during a write operation the first memory element 10 is programmed to logical 1 (the desired value) and the second memory element 10' is programmed to logical 0 (the bit-bar value).

The first memory elements 10 and the second memory element 10' are preferably identical in terms of its materials and dimensions, and co-located (i.e., adjacent each other on a substrate or chip). In this way, the second memory element 10' will have substantially identical electrical characteristics to the first memory element 10 and serves as a local reference element programmed oppositely to the first memory element 10. As discussed above, this allows for the memory cell 100 (or the first memory element 10) to be read by the comparison of read currents *I_{read1}*, *I_{read2}* produced locally at the memory cell 100, as opposed to comparing a read current from a single memory element 10 to a reference current produced from a reference cell located remotely from that memory element, e.g., at the periphery of a memory array and/or in a sense amplifier, as is commonplace in MRAM architectures. The architecture of the memory cell 100 thus avoids the need for separate well-calibrated reference cells that are commonplace in MRAM architectures, and can account for process variations across the memory chip, which is particularly robust and useful for testing memory cells and arrays (at the expense of memory cell footprint). This architecture also provides a solution for use of extremely low read-out voltages by allowing comparison of currents rather than voltages.

In preferred embodiments, the memory cell 100 is as described in GB2576174. In this case, one of the first electrode layer 11 and the second electrode layer 13 of the first FTJ device 10 and the second FTJ device 10' is formed of or comprises a magnetically frustrated antiferromagnetic material. This has advantages in terms of low net magnetic moment and high TER compared to use of non-magnetically frustrated ferromagnetic materials. In one example implementation, the antiferromagnetic material is an antiperovskite material or has an antiperovskite crystal structure, and the ferroelectric tunnel barrier is comprised of a perovskite material or a material with a perovskite crystal structure. The use of a perovskite ferroelectric tunnel barrier in combination with an antiperovskite electrode layer provides high mechanical stability and good lattice match between the individual layers, which in turn promotes high quality interfaces and endurance.

Example antiperovskite materials have a general formula of Mn₃XN where X can, for example, be Ga, Ni, Sn. Preferred examples include Mn₃GaN or Mn₃NiN based materials, such as Mn₃₋ₓAₓGa_{1-y}B_{y}N_{1-z} or Mn₃₋ₓAₓNi_{1-y}B_{y}N_{1-z}, where A and B are one or more elements selected from the list including: Ag, Al, Au, Co, Cu, Fe, Ga, Ge, In, Ir, Ni, Pd, Pt, Rh, Sb, Si, Sn, and Zn, and x, y and z are composition parameters in the range from 0 to 1.

The first access switch 20 and the second access switch 20' comprise one or more transistors, which are preferably normally closed or OFF (i.e., closed or OFF in the absence of an activation signal applied thereto), and further preferably metal-oxide-semiconductor (MOS) transistors. A MOS transistor comprises a source, drain and gate (control input), and can be an n-type (nmos) or p-type (pmos), as is known in the art. The first access switch 20 and the second access switches 20' may comprise one or more nmos transistors, one or more pmos transistors, or a combination of nmos and pmos transistors, as described below.

Figure 4(a) shows a first example configuration of the first access switch 20 and the second access switch 20', comprising a single nmos transistor Tₙ. The nmos transistor Tₙ includes a source 22, drain 23 and control input (gate) 21 connected to the word line WL as shown. One of the source 22 or drain 23 is connected to a first bit line BL or a second bit line BL' and the other of the source 22 or drain 23 is connected to the first electrode layer 11 or the second electrode layer 13 of a memory element 10 or memory element 10'.

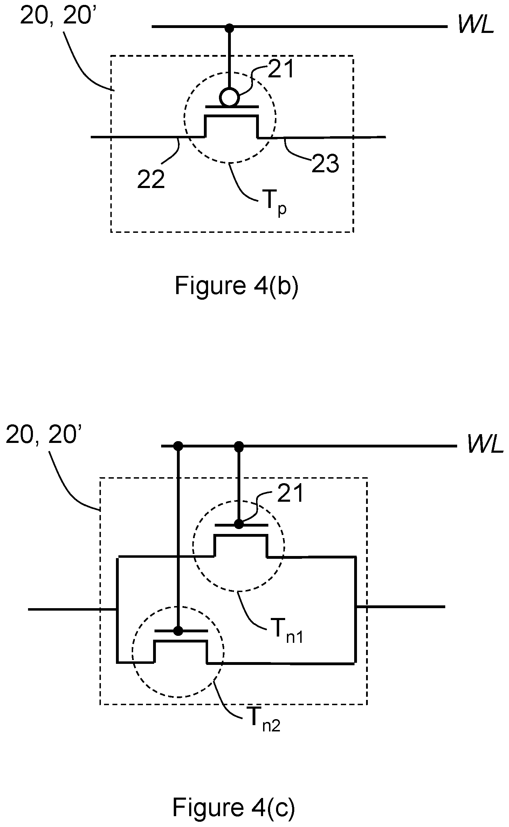

Figure 4(b) shows a second example configuration of the first access switch 20 and the second access switches 20', comprising a single pmos transistor Tₚ. Similarly, the pmos transistor Tₚ includes a source 22, drain 23 and control input (gate) 21 connected to the word line WL, as shown.

Figure 4(c) shows a third example configuration of the first access switch 20 and the second access switches 20', comprising a plurality of a nmos transistors Tₙ₁, Tₙ₂ (two in this example) connected in parallel. In this case, the nmos transistors Tₙ₁, Tₙ₂ are coupled together at their respective sources and drains, and the control input of each nmos transistor Tₙ₁, Tₙ₂ is connected to the word line WL. The access switches 20, 20' may instead comprise a plurality of a pmos MOS transistors Tₚ connected in parallel (not shown). Using multiple transistors in parallel may advantageously reduce the resistance of the first access switches 20 and the second access switches 20' thereby allowing the use of smaller read and write voltages for the memory cell 100.

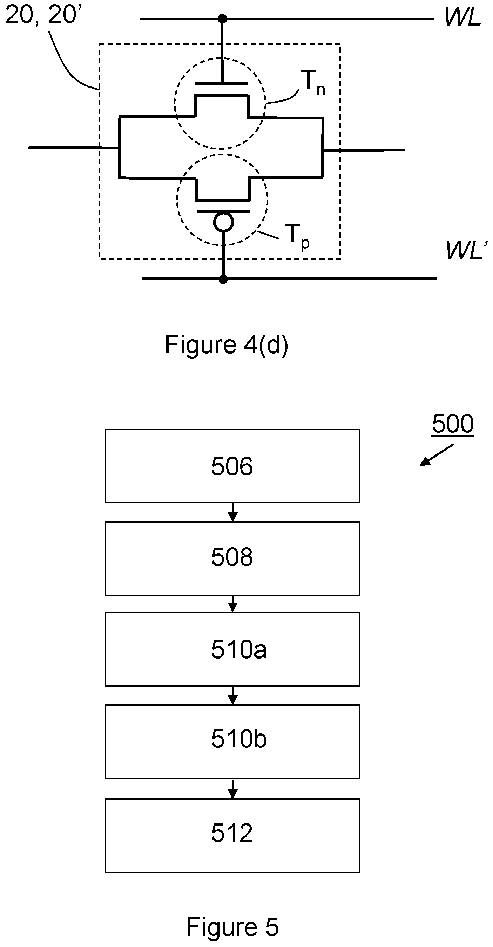

Figure 4(d) shows a fourth example configuration of the first access switch 20 and the second access switches 20', comprising a nmos transistor Tₙ and a pmos transistor Tₚ connected in parallel. The n-type transistor Tₙ and the p-type transistor Tₙ are coupled together at their respective sources and drains, as shown. In figure 4(d), the control input of the nmos transistor Tₙ is connected to the word line WL, and the control input of pmos transistor Tₚ is a connected to a further word line WL' of the memory cell 100 for providing a further activation signal thereto during a read operation and a write operation. It will be appreciated that either of the nmos transistor Tₙ or the pmos transistor Tₚ can be connected to the word line WL or the further word line WL'.

Figure 5 shows a method 500 of performing a write operation on the memory cell 100 described above, according to various embodiments of the invention. Step 508 comprises setting a voltage on the first bit line BL, the second bit line BL', the first source line SL, and the second source line SL' to zero or ground, e.g. using a pre-charge circuit connected to the memory cell 100, as is known in the art. Step 510a comprises applying a first write voltage V_{w1} of a first polarity (a DC voltage) between the first bit line BL and the first source line SL of the memory cell 100. Step 510b comprises applying a second write voltage V_{w2} of a second polarity (a DC voltage) between the second bit line BL' and the second source line SL' of the memory cell 100. The first polarity (i.e. either positive or negative) is determined based on the data bit to be written to the memory cell 100 and the predetermined electrical characteristics of the first FTJ device 10. The second polarity is opposite to the first polarity. Steps 510a and 510b may be preceded by a step 506 of receiving a data signal indicating a logical state, 0 or 1, of the data bit to be written to the memory cell 100, and selecting or determining a positive or negative first polarity of the first write voltage V_{w1} based in part on the data signal. For example, if the data bit to be written is 1, a first polarity is selected or determined which programs the first FTJ device 10 to R_{Low} representing logical 1. With reference to the idealised electrical characteristics of an FTJ device in figure 2, a positive polarity write voltage V_{w1} is required to switch the first FTJ device 10 from R_{High} (logical 0) to R_{Low} (logical 1). Thus, in this example, it can be determined that the first polarity of the first write voltage V_{w1} is positive and the second polarity of the second write voltage V_{w2} is negative. Steps 510a and 510b are preferably performed simultaneously. It will be understood that the precharging step 508 is optional but results in better controlled voltages applied to the first FTJ devices 10 and the second FTJ devices 10'. Steps 508, 510a, 510b thus set up the required write voltages V_{w1}, V_{w2} on the bit and source lines of the memory cell 100.

For example, to program the first memory element 10 to a R_{Low} (logical 1), a positive first write voltage V_{th-P} < V_{w1} < V_{BD-P} is applied between the first bit line BL and the first source line SL. The second memory element 10' is programmed to R_{High} (logical 0) by applying a negative second write voltage |V_{th-N}| < |V_{w2}| < |V_{BD-N}| between the second bit line BL' and the second source line SL'. The opposite is required to programme the first memory element 10 to a R_{High} (logical 0).

Step 512 comprises activating the first access switch 20 and the second access switch 20' of the memory cell 100 to enable the first write voltage V_{w1} and the second write voltage V_{w2} to be applied across the respective first FTJ device 10 and second FTJ device 10' and thereby program the first FTJ device 10 to one of the high or low resistance states based on the first write voltage V_{w1} and program the second FTJ device 10' to the other of the high or low resistance states based on the second write voltage V_{w2}. As discussed previously, the data bit is represented by the resistance states of the first FTJ device 10 and second FTJ device 10'. Step 512 comprises providing a suitable activation signal to the word line WL of the memory cell 100 (which is in turn applied to the control inputs 21, 21') to turn ON the transistors T of the access switches 20, 20'. For example, the activation signal may be a threshold source-gate voltage specific to the type of transistor used, as is known in the art. The activation signal is preferably applied for a predefined period of time, such as the remaining duration of the write operation.

Where the first access switch 20 and the second access switch 20' of the memory cell 100 comprise an nmos transistor Tₙ and a pmos transistor Tₚ connected in parallel as described above with reference to figure 4(d), step 512 of activating the first access switch 20 and the second access switch 20' further comprises providing a further activation signal to the further word line WL' of the memory cell 100. In this case, the activation signals applied to the word line WL and further word line WL' are different, e.g., opposite polarity electrical signals, as required by the different types of transistors. The activation signal and further activation signal are preferably applied simultaneously.

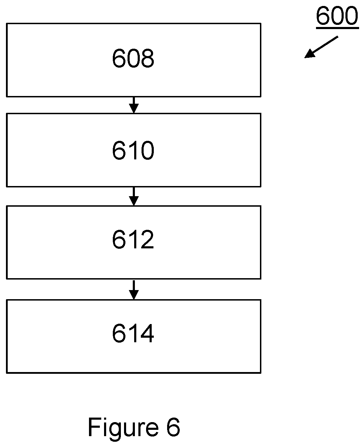

Figure 6 shows a method 600 of performing a read operation on the memory cell 100 described above, according to various embodiments of the invention. Step 608 comprises setting a voltage on the first bit line BL, the second bit line BL', the first source line SL, and the second source line SL' to zero or ground, e.g. using a pre-charge circuit connected to the memory cell 100, as is known in the art. Step 610 comprises applying a read voltage Vᵣ between the first bit line BL and the first source line SL and between the second bit line BL' and the second source line SL' of the memory cell 100. The read voltage Vᵣ must be less than a threshold switching voltage of the respective first FTJ device 10 and second FTJ device 10' to avoid disturbing the resistance/logical state, such that |Vᵣ| < V_{th-P}, |V_{th-N}|. Preferably, the read voltage Vᵣ applied to the first FTJ device 10 and the second FTJ device 10' is a DC voltage with substantially the same amplitude and polarity. It will be understood that the precharging step 608 is optional but results in better controlled voltages applied to the first FTJ device 10 and the second FTJ device 10'. Steps 608 and 610 thus set up the required read voltages Vᵣ on the bit and source lines of the memory cell 100 prior to activating the access switches 20, 20', see below.

Step 612 comprises activating the first access switch 20 and the second access switch 20' of the memory cell 100 to enable the read voltage Vᵣ to be applied across the respective first FTJ device 10 and the second FTJ devices 10' and respective read currents *I_{read1}*, *I_{read2}* to flow therethrough. This step comprises providing a suitable activation signal to the word line WL of the memory cell 100 (which is in turn applied to the control inputs 21, 21') to turn ON the transistors T of the access switches 20, 20', as described for step 512 of the write method 500. The resulting read current *I_{read1}*, *I_{read2}* is inversely proportional to the resistance (logical) state, R_{High} or R_{Low}, of the respective first FTJ devices 10 and second FTJ devices 10'.

Step 614 comprises comparing the read currents *I_{read1}*, *I_{read2}* flowing in the first source line SL and the second source line SL' of the memory cell 100 to determine a data bit stored in the memory cell 100. For example, if the read current *I_{read1}* flowing in the first source line SL associated with the first memory element 10 is greater than the read current *I_{read2}* flowing in the second source line SL' associated with the second memory element 10', it can be deduced that the logical state of the first memory element 10 is 1 (R_{Low}) and the logical state of the second memory element 10' is 0 (R_{High}), and thus, where the first memory element 10 was programmed to the desired data bit value, the stored data bit is 1. Step 614 may comprise measuring or sensing the read currents *I_{read1}*, *I_{read2}* flowing in each of the first source line SL and the second source line SL'. It will be appreciated that only a measure of the relative read currents *I_{read}* flowing in each of the first source line SL and the second source line SL' is required to determine the stored data bit. As such, measuring or sensing the read currents *I_{read1}*, *I_{read2}* need not produce absolute values of read current *I_{read1}*, *I_{read2}.* For example, the read currents *I_{read1}*, *I_{read2}* in the first source line SL and the second source line SL' can be sensed and compared using a current sense amplifier connected to the first source line SL and the second source line SL', whereby the output of the current sense amplifier is a logical level voltage signal proportional to the logical state, 0 or 1, of the data bit stored in the memory cell 100 (e.g., proportional to the logical state of the first memory element 10 where it is programmed to the desired data bit value, or proportional to the logical state of the second memory element 10' where it is programmed to the desired data bit value).

Where the first and second access switches 20, 20' of the memory cell 100 comprise an nmos transistor Tₙ and a pmos transistor Tₚ connected in parallel as described above with reference to figure 4(d), step 612 further comprises providing a further activation signal to the further word line WL' of the memory cell 100. The activation signal and further activation signal are preferably applied simultaneously.

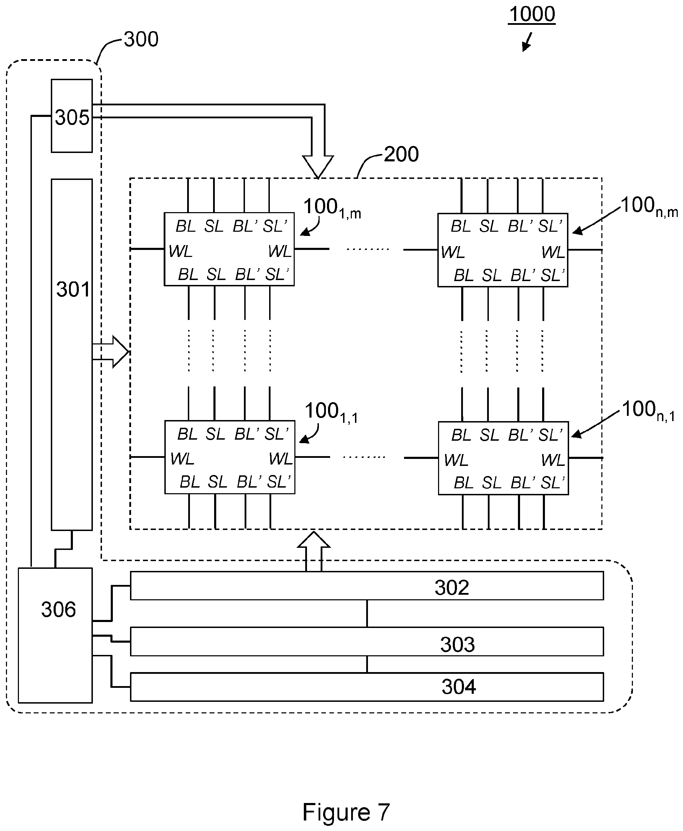

Figure 7 shows a non-volatile FReRAM architecture 1000 according to an embodiment of the invention. The FReRAM architecture 1000 comprises an array 200 of ferroelectric resistive memory cells 100, as described above, arranged in a plurality of *n* rows and m columns, whereby the respective first bit lines BL, second bit lines BL', first source lines SL and second source lines SL' of the memory cells 100 in the same column are serially connected, and the respective word lines WL (and where present, the further word lines WL') of the memory cells 100 in the same row are serially connected. The FReRAM architecture 1000 further comprises suitable peripheral control circuitry 300 coupled to the array 200 of memory cells 100 for performing the voltage-driven read and/or write operations on individual selected memory cells 100 of the array 200 described above with reference to figures 5 and 6. In figure 7, an individual memory cell 100 in the array 200 is referenced as 100_{x, y}, where 0 ≤ x ≤ *n-*1 and 0 ≤ y ≤ *m*-1 indicate the respective row and column index/address of the memory cell 100. Although four memory cells 100 are shown arranged in a 2x2 array 200 in this illustrative example, it will be appreciated that in practice the array 200 can comprise any number of memory cells 100_{x,y} arranged in *n* rows and *m* columns, where *n* and *m* need to not be equal.

The peripheral control circuitry 300 is configured to perform or execute a read operation and/or a write operation on a selected memory cell 100 in response to one or more input signals indicating a read and/or write operation and the row and column address of a selected memory cell 100 for reading and/or writing. During a read operation, the peripheral control circuitry 300 is configured, to: apply a read voltage Vᵣ between the first bit line BL and the first source line SL and between the second bit line BL' and the second source line SL' of a column of memory cells 100 containing the selected memory cell 100 for reading; activate the first access switch 20 and the second access switch 20' of the selected memory cell 100 by providing an activation signal to the word line WL (and where present, the further word line WL') of a row of memory cells 100 containing the selected memory cell 100 to thereby enable read currents *I_{read1}*, *I_{read2}* to flow through the first FTJ device 10 and the second FTJ device 10' of the selected memory cell 100; and compare the read current *I_{read1}*, *I_{read2}* in the first source line SL and the second source line SL' of the selected column of memory cells 100 to determine a data bit stored in the selected memory cell 100. During a write operation, the peripheral control circuitry 300 is configured to: apply a first write voltage V_{w1} of a first polarity between the first bit line BL and the first source line SL of a column of memory cells 100 containing a selected memory cell 100 for writing, wherein the first polarity is based on a data bit to be written to the selected memory cell 100; apply a second write voltage V_{w2} of a second polarity between the second bit line BL' and the second source line SL' of the column of memory cells 100 containing the selected memory cell 100, wherein the second polarity is opposite to the first polarity; and activate the first access switch 20 and the second access switch 20' of the selected memory cell 100 by providing an activation signal to the word line WL (and where present, the further word line WL') of a row of memory cells 100 containing the selected memory cell 100, to thereby program the first FTJ device 10 of the selected memory cell 100 to one of the high or low resistance states based on the first write voltage V_{w1} and program the second FTJ device 10' of the selected memory cell 100 to the other of the high or low resistance states based on the second write voltage V_{w2}.

In the illustrated embodiment, the peripheral control circuitry 300 comprises a plurality of components including a row decoder 301, a column selector 302, a read-write driver 303 and a current sense amplifier 304, a pre-charge circuit 305 and a controller 306 coupled to the row decoder 301, column selector 302, read-write driver 303, current sense amplifier 304 and pre-charge circuit 305 for controlling the read and/or write operations, as described in more detail below. It will be appreciated that peripheral control circuitry 300 may comprise additional components, such as a voltage source and/or data in/out buffer (not shown), as are known in the art. The controller 306 is configured, in response to receiving one or more input signals indicating a respective read or write operation and the row and column address of a selected memory cell 100 for reading and/or writing, to provide various control signals to the components 301, 302, 303, 304, 305 to execute to the read and/or write operation.

The row decoder 301 is coupled to the word lines WL (and where present, the further word lines WL') of each row of memory cells 100 for selecting a row of memory cells 100 for a read and/or write operation in response to a row address enable signal RAD EN provided by the controller 306. The column selector 302 is coupled to the first bit line BL and the second bit line BL' and the first source line SL and the second source line SL' of each column of memory cells 100 for selecting a column of memory cells 100 for a read and/or write operation in response to a column address enable signal CAD EN provided by the controller 306. The read-write driver 303 is coupled to the column selector 302 for applying a read voltage Vᵣ or appropriate write voltages V_{w1}, V_{w2} to the selected column of memory cells 100 during a respective read and/or write operation in response to a read enable signal READ EN or a write enable signal WRITE EN provided by the controller 306. The current sense amplifier 304 is also coupled to the column selector 302, and is configured to compare read currents *I_{read1}*, *I_{read2}* in the first source line SL and the second source line SL' of the selected column of memory cells 100 during a read operation and provide an output signal proportional to a logical state, 0 or 1, of the data bit of (or stored in) the selected memory cell 100 in response to a sense amplifier enable signal SA EN provided by the controller 306. The pre-charge circuit 305 is coupled to the first bit line BL and the second bit line BL' and the first source line SL and the second source line SL' of each column of memory cells 100 for setting their respective voltages to zero or ground, in response to a pre-charge enable signal PRECH EN provided from the controller 306.

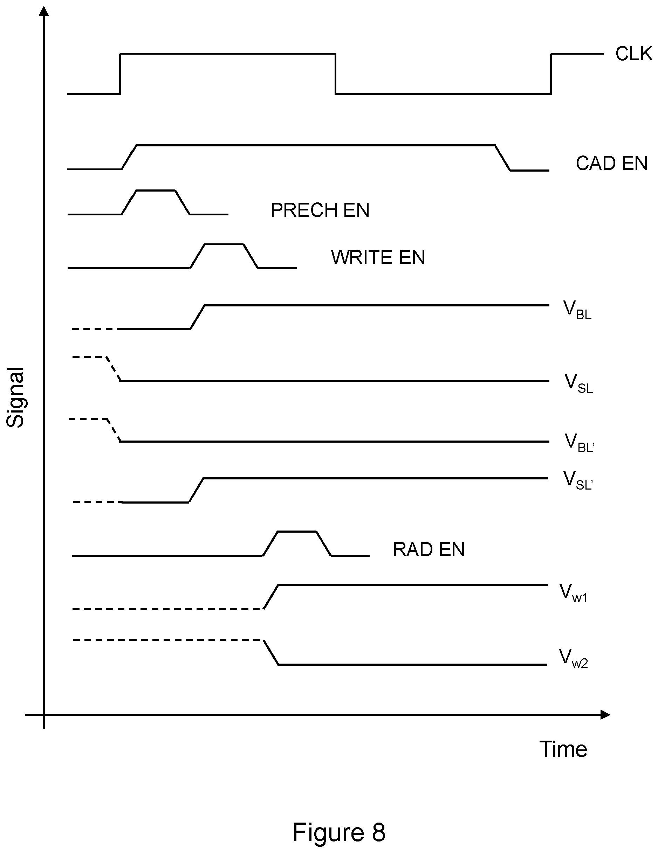

Figure 8 shows a schematic timing diagram of the signals CAD EN, PRECH EN, V_{BL}, V_{SL}, V_{BL'}, V_{SL'}, RAD EN, V_{w1}, and V_{w2} involved in an example write operation using the FReRAM 1000. Here, signals V_{BL}, V_{SL}, V_{BL'}, V_{SL}, represent the voltages on the respective first bit line BL, first source line, SL, second bit line BL' and second source line SL', and signals V_{w1} and V_{w2} represent the first write voltage and the second write voltage applied across the respective first FTJ device 10 and second FTJ device 10' of the selected memory cell 100. The dashed portions of the signals indicate arbitrary signal levels in the array 200 prior to the write operation which have no bearing on the outcome of the write operation. The write operation is preferably performed within a clock cycle of the controller 306, as indicated by the signal CLK.

The write operation is initiated by one or more input signals provided to the controller 306 (not shown) indicating a write operation and the row and column address of a selected memory cell 100 for writing.

The data bit, 0 or 1, to be written to the selected memory cell 100 is encoded in an input data signal, which may for example be provided to the controller 306 or a data in/out buffer coupled to the read-write driver 303 (not shown). The first polarity of the first write voltage V_{w1} is set or determined based on the input data signal and the predetermined electrical characteristics of the FTJ devices 10, 10'. In practice, the polarities of the first write voltage V_{w1} and the second write voltage V_{w2} can be determined based on the input data signal using a look-up table or other means of conversion stored in the controller 306 and/or read-write driver 303.

The write operation is preferably initiated at the beginning of a clock cycle. Before the start of a write (or read) operation, no activation signals are applied to the word lines WL (or further word lines WL', where present) of the array 200, such that no voltage is applied to the first FTJ device 10 and the second FTJ device 10' of the memory cells 100. In response to initiation of the write operation, a PRECH EN signal is provided to the pre-charge circuit 305 for a predefined period of time (e.g., some fraction of the clock cycle) sufficient to pre-charge or set the first bit line BL and the second bit line BL' and the first source line SL and the second source line SL' of each column of memory cells 100 to zero voltage or ground. A CAD EN signal is provided (at the same time or after PRECH EN) to the column selector 302 to select a column containing the selected memory cell 100 for writing and thereby enable signal access to the selected column. The CAD EN signal is provided for the remainder of the write operation. Next, after the PRECH EN signal has ended, a WRITE EN signal is provided to the read-write driver 303 to enable it to apply, through the column selector 302, the appropriate opposite polarity first write voltage V_{w1} and second write voltage V_{w2} to the selected column of memory cells 100, as indicated by the changes in V_{BL}, V_{SL}, V_{BL'}, V_{SL'}. At this time, the voltages on the bit lines BL, BL' and source lines SL, SL' of the selected column are set up, but write voltages V_{w1}, V_{w2} are not applied across the first FTJ device 10 and the second FTJ device 10' of the memory cells 100 until the RAD EN signal is subsequently provided. Next, a RAD EN signal is provided to the row decoder 301 to select a row of memory cells 100 containing the selected memory cell 100 and enable an activation signal to be applied to the word line WL (and, where present, the further word line WL') of the selected row of memory cells 100. At this time, the first write voltage V_{w1} and the second write voltage V_{w2} are applied across the respective first FTJ device 10 and second FTJ device 10' of the selected memory cell 100 to program the memory cell 100, as indicated by the signals V_{w1} and V_{w2}. The RAD EN signal is provided for a predefined period of time (e.g., some fraction of the clock cycle), after which the write operation is completed, and the CAD EN signal can end.

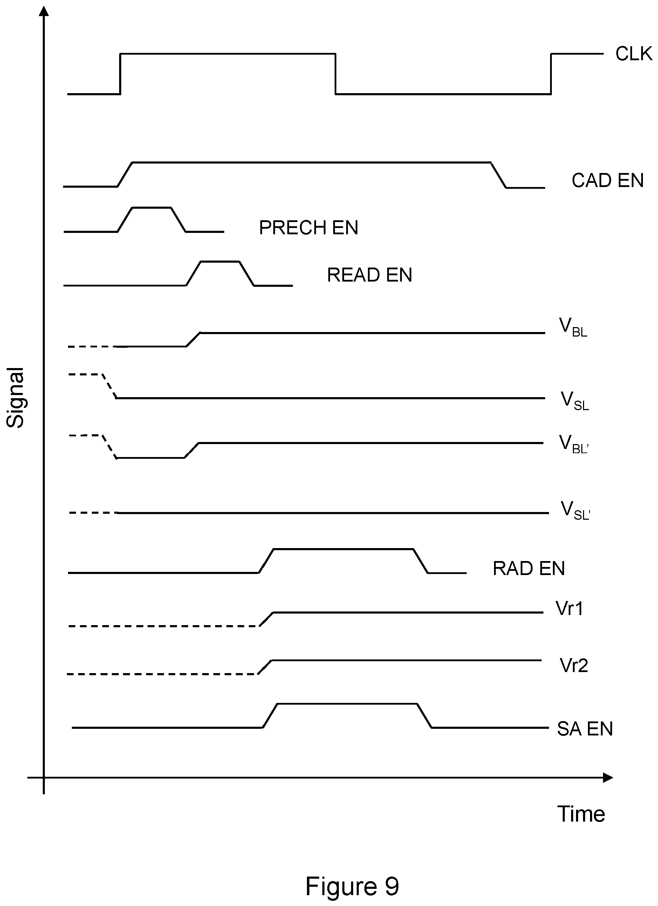

Figure 9 shows a schematic timing diagram of the signals CAD EN, PRECH EN, V_{BL}, V_{SL}, V_{BL'}, V_{SL'}, RAD EN, SA EN, Vᵣ₁, and Vᵣ₂ involved in an example read operation using the FReRAM 1000. Signals V_{BL}, V_{SL}, V_{BL'}, V_{SL}, represent the voltages on the respective first bit line BL, first source line, SL, second bit line BL' and second source line SL', and signals Vᵣ₁ and Vᵣ₂ represent the read voltages applied across the respective first FTJ device 10 and second FTJ device 10' of the selected memory cell 100. The dashed portions of the signals indicate arbitrary signal levels in the array 200 prior to the read operation which have no bearing on the outcome of the read operation. The read operation is also preferably performed within a clock cycle of the controller 306, as indicated by the signal CLK.

The read operation is initiated by one or more input signals provided to the controller 306 (not shown) indicating a read operation and the row and column address of a selected memory cell 100 for reading. The read operation is preferably initiated at the beginning of a clock cycle. Before the start of a read operation, no activation signals are applied to the word lines WL (or further word lines WL', where present) of the array 200, such that no voltage is applied to the first FTJ device 10 and the second FTJ device 10' of the memory cells 100. As with the write operation, in response to initiation of the read operation, a PRECH EN signal is provided to the pre-charge circuit 305 for a predefined period of time (e.g., some fraction of the clock cycle) sufficient to pre-charge or set the first bit line BL and the second bit line BL' and the first source line SL and the second source line SL' of each column of memory cells 100 to zero voltage or ground. A CAD EN signal is provided (at the same time as, or slightly delayed after, the PRECH EN signal) to the column selector 302 to select a column containing the selected memory cell 100 for read and thereby enable signal access to the selected column. The CAD EN signal is provided for the remainder of the read operation. Next, after the PRECH EN signal has ended, a READ EN signal is provided to the read-write driver 303 to enable it to apply, through the column selector 302, the appropriate read voltages Vᵣ₁, Vᵣ₂ to the selected column of memory cells 100, which are preferably the same, as indicated by the changes in V_{BL}, V_{SL}, V_{BL'}, V_{SL'}. At this time, the voltages on the bit lines BL, BL' and source lines SL, SL' of the selected column are set up, but read voltages Vᵣ₁, Vᵣ₂ are not applied across the first FTJ device 10 and the second FTJ device 10' of the memory cells 100, and associated read currents *I_{read1}*, *I_{read2}* cannot flow, until the RAD EN signal is subsequently provided. Next, a RAD EN signal is provided to the row decoder 301 to select a row of memory cells 100 containing the selected memory cell 100 and enable an activation signal to be applied to the word line WL (and, where present, the further word line WL') of the selected row of memory cells 100. At this time, the read voltages Vᵣ₁, Vᵣ₂ are applied across the respective first FTJ device 10 and second FTJ device 10' of the selected memory cell 100, as indicated by the signals Vᵣ₁ and Vᵣ₂, causing a respective read current *I_{read1}*, *I_{read2}* to flow in the first source line SL and the second source line SL'. An SA EN signal is then provided (simultaneously with, or slightly delayed after, the RAD EN signal) to the current sense amplifier 304 to enable comparison of the read currents *I_{read1}*, *I_{read2}* in the first source line SL and the second source line SL' and determination of the data bit stored in the selected memory cell 100. The RAD EN signal and the SA EN signal are provided for a predefined period of time (e.g., some fraction of the clock cycle), after which the write operation is completed, and the CAD EN signal can end.

It will be understood that the present invention has been described above purely by way of example, and modifications of detail can be made within the scope of the invention. Each feature disclosed in the description, and (where appropriate) the claims and drawings may be provided independently or in any appropriate combination.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. Reference numerals appearing in the claims are by way of illustration only and shall have no limiting effect on the scope of the claims.

## Claims

1. A non-volatile memory cell, comprising:
a first memory element comprising a first ferroelectric tunnel junction device programmable to one of a high or low resistance state; and
a second memory element comprising a second ferroelectric tunnel junction device programmable to the other of a high or low resistance state;
wherein the memory cell stores a data bit represented by the opposite resistance states of the first ferroelectric tunnel junction device and the second ferroelectric tunnel junction device.

2. The memory cell of claim 1, wherein the first ferroelectric tunnel junction device is programmed to one of the high or low resistance states corresponding to a data bit, and the second ferroelectric tunnel junction device is programmed to the other of the high or low resistance states corresponding to the logical complement of the data bit.

3. The memory cell of claim 1 or 2, wherein the first ferroelectric tunnel junction device and the second ferroelectric tunnel junction device are substantially identical and co-located; and/or
wherein the data bit is readable by comparison of the resistance states of the first ferroelectric tunnel junction device and the second ferroelectric tunnel junction device during a read operation, and wherein the second memory element is a reference cell.

4. The memory cell of any preceding claim, comprising:
a first bit line, a first source line, and a first access switch, wherein the first memory element and the first access switch are connected in series between the first bit line and the first source line;
a second bit line, a second source line, and a second access switch, wherein the second memory element and the second access switch are connected in series between the second bit line and the second source line; and
a word line connected to a control input of the first access switch and to a control input of the second access switch for providing an activation signal thereto during a read operation and/or a write operation.

5. The memory cell of any preceding claim, wherein the first ferroelectric tunnel junction device and the second ferroelectric tunnel junction device each comprise a first electrode layer and a second electrode layer separated by a ferroelectric tunnel barrier, and
wherein the ferroelectric tunnel barrier comprises a ferroelectric material with a perovskite crystal structure; and
wherein at least one of the first electrode layer and the second electrode layer comprises:
(i) a magnetically frustrated material, preferably comprised of an antiferromagnetic material with an anti-perovskite crystal structure; or
(ii) a material with an anti-perovskite crystal structure.

6. The memory cell of any preceding claim, wherein the first access switch and the second access switch each comprise a plurality of transistors connected in parallel; and, optionally or preferably,
wherein the first access switch and the second access switch each comprise an n-type transistor and a p-type transistor connected in parallel, wherein each n-type transistor has a control input connected to a word line for providing an activation signal thereto during a read operation and/or a write operation, and
wherein the memory cell comprises a further word line connected to a control input of the p-type transistor of the first access switch and the second access switch for providing an activation signal thereto during a read operation and/or a write operation.

7. A method of performing a write operation on the non-volatile memory cell of any of claims 1 to 6, comprising:
applying a first write voltage of a first polarity across the first ferroelectric tunnel junction device of the first memory cell to program the first ferroelectric tunnel junction device to one of the high or low resistance states, wherein the first polarity is based on a data bit to be written to the memory cell; and
applying a second write voltage of a second polarity across the second ferroelectric tunnel junction device of the second memory cell to program the second ferroelectric tunnel junction device to the other of the high or low resistance states, wherein the second polarity is opposite to the first polarity; and
wherein the data bit is represented by the opposite resistance states of the first ferroelectric tunnel junction device and second ferroelectric tunnel junction device; and, optionally or preferably
receiving a data signal indicating a logical state, 0 or 1, of the data bit to be written to the memory cell; and
selecting a positive or negative first polarity of the first write voltage based on the data signal.

8. The method of claim 7, wherein the memory cell comprises: a first bit line, a first source line, and a first access switch, wherein the first memory element and the first access switch are connected in series between the first bit line and the first source line; a second bit line, a second source line, and a second access switch, wherein the second memory element and the second access switch are connected in series between the second bit line and the second source line; and a word line connected to a control input of the first access switch and to a control input of the second access switch for providing an activation signal thereto; and
wherein the method comprises:
applying the first write voltage of the first polarity between the first bit line and the first source line of the memory cell;
applying the second write voltage of the second polarity, between the second bit line and the second source line of the memory cell; and
activating the first access switch and the second access switch of the memory cell by providing an activation signal to the word line of the memory cell, wherein activating the first access switch and the second access switch enables the first write voltage and the second write voltage to be applied across the respective the first ferroelectric tunnel junction device and the second ferroelectric tunnel junction device to thereby program the first ferroelectric tunnel junction device to the one of the high or low resistance states based on the first write voltage and program the second ferroelectric tunnel junction device to the other of the high or low resistance states based on the second write voltage; and, optionally or preferably,
prior to applying the first write voltage and the second write voltage: setting a voltage on the first bit line, the second bit line, the first source line, and the second source line to zero voltage or ground; and/or
wherein the first access switch and the second access switch of the memory cell each comprise an n-type transistor and a p-type transistor connected in parallel, each n-type transistor having a control input connected to the word line and each p-type transistor having a control input connected to a further word line of the memory cell, and
wherein the step of activating the first access switch and the second access switch of the memory cell further comprises providing an activation signal to the further word line of the memory cell.

9. A method of performing a read operation on the non-volatile memory cell of any of claims 1 to 6, comprising:
applying a read voltage across the first ferroelectric tunnel junction device of the first memory cell to thereby produce a first read current flowing through the first ferroelectric tunnel junction device;
applying a read voltage across the second ferroelectric tunnel junction device of the second memory cell to thereby produce a second read current flowing through the second ferroelectric tunnel junction device; and
comparing the first read current and the second read current to determine a data bit stored in the memory cell.

10. The method of claim 9, wherein the memory cell comprises: a first bit line, a first source line, and a first access switch, wherein the first memory element and the first access switch are connected in series between the first bit line and the first source line; a second bit line, a second source line, and a second access switch, wherein the second memory element and the second access switch are connected in series between the second bit line and the second source line; and a word line connected to a control input of the first access switch and to a control input of the second access switch for providing an activation signal thereto; and
wherein applying the read voltage across the first ferroelectric tunnel junction device and the second ferroelectric tunnel junction device comprises:
applying a read voltage between the first bit line and the first source line and between the second bit line and the second source line of the memory cell to thereby produce the first read current and the second read current; and
activating the first access switch and second access switch of the memory cell by providing an activation signal to the word line of the memory cell, wherein activating the first access switch and the second access switch enables the first read current to flow through the first ferroelectric tunnel junction device and the second read current to flow through the second ferroelectric tunnel junction device of the memory cell; and, optionally or preferably,
prior to applying the read voltage: setting a voltage on the first bit line, the second bit line, the first source line, and the second source line to zero or ground; and/or
wherein the first access switch and the second access switch of the memory cell each comprise an n-type transistor and a p-type transistor connected in parallel, each n-type transistor having a control input connected to the word line and each p-type transistor having a control input connected to a further word line of the memory cell, and
wherein the step of activating the first access switch and the second access switch of the memory cell further comprises providing an activation signal to the further word line of the memory cell.

11. The method of claim 10, wherein comparing the first read current and the second read current to determine a data bit of the memory cell comprises using a current sense amplifier connected to the first source line and the second source line, and wherein the output of the current sense amplifier is proportional to a logical state, 0 or 1, of the data bit.

12. A random-access memory, comprising:
an array of non-volatile memory cells as defined in any of claims 1 to 6 arranged in a plurality of rows and columns, wherein each memory cell comprises:
a first bit line, a first source line, and a first access switch, wherein the first memory element and the first access switch are connected in series between the first bit line and the first source line;
a second bit line, a second source line, and a second access switch, wherein the second memory element and the second access switch are connected in series between the second bit line and the second source line; and
a word line connected to a control input of the first access switch and to a control input of the second access switch for providing an activation signal thereto; and
wherein the respective first bit lines, second bit lines, first source lines and second source lines of the memory cells in the same column are serially connected; and wherein the respective word lines of the memory cells in the same row are serially connected; and
a peripheral control circuit coupled to the array of memory cells for performing voltage-driven read and/or write operations on a selected memory cell of the array, wherein the peripheral control circuit is configured, during a read operation, to:
apply a read voltage between the first bit line and the first source line and between the second bit line and the second source line of a column of memory cells containing a selected memory cell for reading;
activate the first access switch and the second access switch of the selected memory cell by providing an activation signal to the word line of a row of memory cells containing the selected memory cell to thereby enable a current to flow through the first ferroelectric tunnel junction device and the second ferroelectric tunnel junction device of the selected memory cell; and
compare the currents in the first source line and the second source line of the selected column of memory cells to determine a data bit stored in the selected memory cell; and wherein the peripheral control circuit is further configured, during a write operation, to:
apply a first write voltage of a first polarity between the first bit line and the first source line of a column of memory cells containing a selected memory cell for writing, wherein the first polarity is based on a data bit to be written to the selected memory cell;
apply a second write voltage of a second polarity between the second bit line and the second source line of the column of memory cells containing the selected memory cell, wherein the second polarity is opposite to the first polarity; and
activate the first access switch and the second access switch of the selected memory cell by providing an activation signal to the word line of a row of memory cells containing the selected memory cell, to thereby program the first ferroelectric tunnel junction device of the selected memory cell to one of the high or low resistance states based on the first write voltage and program the second ferroelectric tunnel junction device of the selected memory cell to the other of the high or low resistance states based on the second write voltage.

13. The random-access memory of claim 12, wherein the peripheral control circuit is further configured to do at least one of the following:
(i) receive a data signal indicating a logical state, 0 or 1, of the data bit to be written to the selected memory cell, and select a positive or negative first polarity of the first write voltage based on the data signal;
(ii) prior to applying the read voltage and the first write voltage and the second write voltage: set a voltage on the first bit line, the second bit line, the first source line, and the second source line to zero voltage or ground, and
(iii) perform a read or write operation within a clock cycle.

14. The random-access memory of claim 12 or 13, wherein the first access switch and the second access switch of each memory cell of the array each comprise an n-type transistor and a p-type transistor connected in parallel, each n-type transistor having a control input connected to the word line of the respective memory cell and each p-type transistor having a control input connected to a further word line of the respective memory cell, wherein the respective further word lines of the memory cells in the same row are serially connected, and
wherein the peripheral control circuit is further configured, during the read and/or write operations, to activate the first access switch and the second access switch of the selected memory cell by further providing an activation signal to the further word line of the row of memory cells containing of the selected memory cell.

15. The random-access memory of any of claims 12 to 14, wherein the peripheral control circuit comprises:
a row decoder coupled to the word lines of each row of memory cells for selecting a row of memory cells for a read or write operation;
a column selector coupled to the first bit line and the second bit line and the first source line and the second source line of each column of memory cells for selecting a column of memory cells for a read or write operation;
a pre-charge circuit coupled to the first bit line and the second bit line and the first source line and the second source line of each column of memory cells for setting their respective voltages to zero voltage or ground;
a read-write driver coupled to the column selector for applying a read or write voltage to the selected column of memory cells during a respective read or write operation;
a current sense amplifier coupled to the column selector, the current sensor amplifier configured to compare currents in the first source line and the second source line of the selected column of memory cells during a read operation and provide an output signal proportional to a logical state, 0 or 1, of the data bit of the selected memory cell; and
a controller coupled to the row decoder, column selector, pre-charge circuit, read-write driver and current sense amplifier for controlling the read and/or write operations; and, optionally or preferably:
wherein the controller is further configured, in response to receiving a write input signal indicating the row and column address of a selected memory cell for writing, to:
provide a row address signal to the row decoder to select a row containing the selected memory cell for writing and provide a column address signal to the column selector to select a column containing the selected memory cell for writing;
provide an enable signal to the pre-charge circuit to set the first bit line, the second bit line, the first source line, and the second source line of the selected column of memory cells to zero voltage or ground;
provide a write enable signal to the read-write driver to apply, through the column selector, the first write voltage between the first bit line and the first source line of the selected column of memory cells and the second write voltage between the second bit line and the second source line of the selected column of memory cells, wherein the polarity of the first write voltage is based on an input data signal indicating a logical state, 0 or 1, of the data bit to be written to the selected memory cell; and
provide an activation signal to the word line of the selected row of memory cells; and/or
wherein the controller is further configured, in response to receiving a read input signal indicating the row and column address of a selected memory cell for reading, to:
provide a row address signal to the row decoder to select a row containing the selected memory cell for reading and provide a column address signal to the column selector to select a column containing the selected memory cell for reading;
provide an enable signal to the pre-charge circuit to set the first bit line, the second bit line, the first source line, and the second source line of the selected column of memory cells to zero voltage or ground;
provide a read enable signal to the read-write driver to apply, through the column selector, the read voltage between the first bit line and the first source line and between the second bit line and the second source line of the selected column of memory cells; and
provide an activation signal to the word line of the selected row of memory cells.
